(19) Europäisches Patentamt
European Patent Office
Office européen des brevets

(11) **EP 2 096 631 A1**

(12) **EUROPEAN PATENT APPLICATION**
published in accordance with Art. 153(4) EPC

(43) Date of publication:
**02.09.2009 Bulletin 2009/36**

(51) Int Cl.:
**G10L 19/14** (2006.01)     **G10L 11/00** (2006.01)

(21) Application number: **07859788.7**

(22) Date of filing: **12.12.2007**

(86) International application number:
**PCT/JP2007/073968**

(87) International publication number:
**WO 2008/072671 (19.06.2008 Gazette 2008/25)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **13.12.2006 JP 2006336272**

(71) Applicant: **Panasonic Corporation**
**Kadoma-shi**
**Osaka 571-8501 (JP)**

(72) Inventors:
• **MORII, Toshiyuki,**
**Chuo-Ku, Osaka 540-6207 (JP)**
• **OSHIKIRI, Masahiro**
**Chuo-Ku, Osaka 540-6207 (JP)**

(74) Representative: **Grünecker, Kinkeldey,**
**Stockmair & Schwanhäusser**
**Anwaltssozietät**
**Leopoldstrasse 4**
**80802 München (DE)**

(54) **AUDIO DECODING DEVICE AND POWER ADJUSTING METHOD**

(57)     Provided is an audio decoding device capable of obtaining a preferable synthesized sound with a stable sound volume. The audio decoding device includes: a post filter (210) which performs a process for improving subjective quality of audio and a process for improving subjective quality of a steady-state noise on an output signal of a synthesis filter (209); an amplitude ratio/ change amount calculation unit (211) which calculates the amplitude ratio of the input signal and the output signal of the post filter (210) and calculates the fluctuation amount of the amplitude ratio for each of sub-frames; a smoothing coefficient setting unit (212) sets a smoothing coefficient on each of the sub-frames by using the amplitude ratio of the input signal and the output signal of the post filter (210) and the fluctuation amount of the amplitude ratio; an adjustment coefficient setting unit (213) which sets an adjustment coefficient for each sample by using the amplitude ratio of the input signal and the output signal of the post filter (210) and the smoothing coefficient; and a power adjusting unit (214) which multiplies the output signal of the post filter (210) by the adjustment coefficient so as to adjust the power of the output signal of the post filter (210).

FIG.2

**Description**

Technical Field

The present invention relates to a speech decoding apparatus and power adjusting method for decoding an encoded speech signal.

Background Art

In mobile communication, it is necessary to compress and encode digital information such as speech and images to efficiently utilize radio channel capacity and a storing medium, and, therefore, many encoding/decoding schemes have been developed so far.

Among these techniques, performance of the speech coding technique has significantly improved thanks to the fundamental scheme "CELP (Code Excited Linear Prediction) " of ingeniously applying vector quantization by modeling the vocal tract system. Further, performance of a sound coding technique such as audio coding has improved significantly thanks to transform coding techniques (MPEG standard ACC, MP3 and the like).

Here, as processing subsequent to a decoder of a low bit rate, post-filtering is generally applied to synthesized sound before the synthesized sound is outputted. Almost all standard codecs for mobile telephones use this post filtering. Post filtering for CELP uses a pole-zero type (i.e. ARMA type) pole emphasis filter using LPC parameters, high frequency band emphasis filter and pitch filter.

However, when emphasis processing is performed by a post filter, the power of an output signal of the post filter fluctuates compared to an input siganl. Therefore, it is necessary to match the power of the output signal of the post filter with the input signal.

The power of this output signal of the post filter is adjusted by finding the power ratio of the input signal and the output signal of a post filter, finding adjusting coefficients based on the power ratio and multiplying the output signal of the post filter by the adjusting coefficients.

Patent Document 1 and Patent Document 2 disclose techniques of finding adjusting coefficients and using smoothing coefficients such that power is adjusted gradually on a per sample basis. Further, when the smoothing coefficients are $\alpha$, $(1-\alpha)$ are accelerating coefficients.

Patent Document 1: Japanese Patent Application Laid-Open No.HEI9-190195
Patent Document 2: Japanese Patent Application Laid-Open No.HEI9-127996

Disclosure of Invention

Problems to be Solved by the Invention

A post filter provides a significant filter gain in the portion where power rises such as the onset portion of speech, and the power of the output signal of the post filter is likely to suddenly increase significantly than the power of the input signal, and, therefore, the power adjusting coefficients need to be adapted promptly in this case. Further, when the input/output power ratio of the post filter fluctuates significantly over time, adjustment is necessary promptly. By contrast with this, if adjusting coefficients are changed suddenly in a period in which input/output power fluctuation of the post filter is little or in a period of stationary speech such as vowels, distortion of sound quality causes a problem and, consequently, the adjusting coefficients are preferably adapted slowly.

However, with any of the above conventional techniques, the smoothing coefficients are fixed and the extent the adjusting coefficients change is constant on a per condition basis. Consequently, according to conventional techniques, it is not possible to produce good synthesized sound with a stable sound volume.

It is therefore an object of the present invention to provide a speech decoding apapratus and power adjusting method for producing good synthesized sound with a stable sound volume.

Means for Solving the Problem

A speech decoding apparatus according to the present invention employs a configuration including: a post filter that applies filtering to a signal of a subframe length at predetermined sample timing intervals; a calculating section that calculates a first calculation value and a second calculation value on a per subframe basis, the first calculation value including an amplitude ratio or a power ratio of an input signal and an output signal of the post filter, the second calculation value including an amount of fluctuation of the first calculation value; a smoothing coefficient setting section that sets a smoothing coefficient on a per subframe basis based on the first calculation value and the second calculation value; an adjusting coefficient setting section that sets an adjusting coefficient on a per sample basis based on the first calculation value and the smoothing coefficient; and a power adjusting section that acquires a decoded speech signal by multiplying the output signal of the post filter by the adjusting coefficient.

A power adjusting method according to the present invention for an output signal of a post filter for applying filtering to a signal of a subframe length at predetermined sample timing intervals, includes: calculating a first calculation value and a second calculation value on a per subframe basis, the first calculation value including an amplitude ratio or a power ratio of an input signal and the output signal of the post filter, the second calculation value including an amount of fluctuation of the first calculation value; setting a smoothing coefficient on a per subframe basis based on the first calculation value and the second calculation value; setting an adjusting coefficient on a per sample basis based on the first calculation value and the smoothing coefficient; and multiplying the output signal of the post filter by the adjusting coefficient.

Advantageous Effect of the Invention

According to the present invention, it is possible to adjust power promptly when a post filter changes power significantly or fluctuates the power ratio significantly over time, and realize smooth power adjustment without discontinuity in a period in which the post filter fluctuates power little or in a stationary period of, for example, vowels. Consequently, it is possible to produce good synthesized sound with a stable sound volume according to the present invention.

Brief Description of Drawings

FIG.1 is a block diagram showing a configuration of a speech encoding apparatus that transmits encoded data to a speech decoding apparatus according to an embodiment of the present invention;
FIG.2 is a block diagram showing a configuration of the speech decoding apparatus according to an embodiment of the present invention;
FIG.3 is a flowchart explaining a power adjustment algorithm in the speech decoding apparatus according to an embodiment of the present invention; and
FIG.4 is a flowchart explaining a power adjustment algorithm in the speech decoding apparatus according to an embodiment of the present invention.

Best Mode for Carrying Out the Invention

An embodiment of the present invention will be explained below with reference to the accompanying drawings.

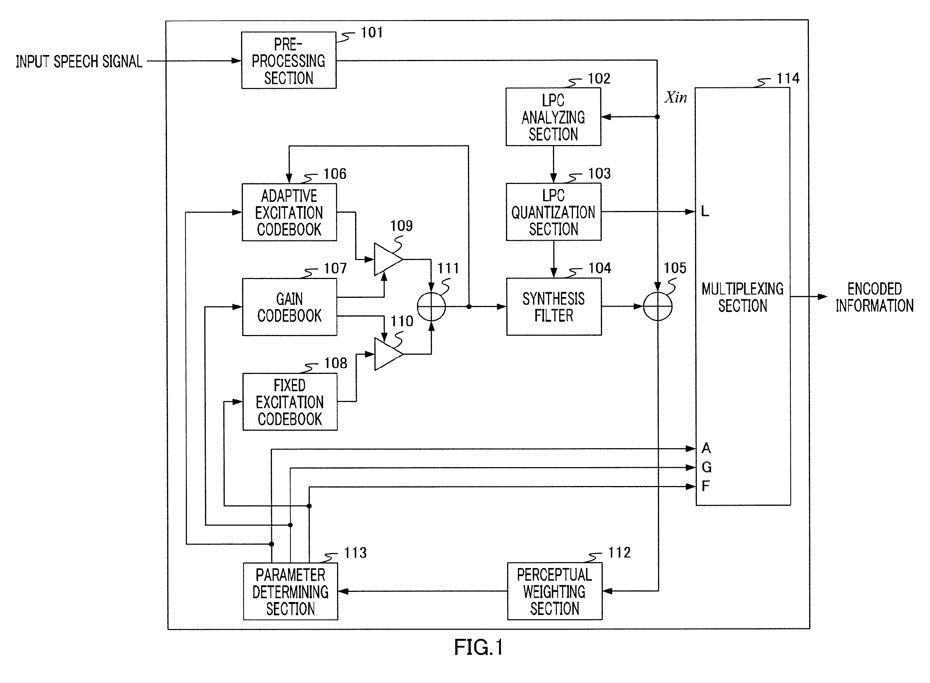

FIG.1 is a block diagram showing a configuration of a speech encoding apparatus that transmits encoded data to a speech decoding apparatus according to the present embodiment.
Pre-processing section 101 performs high pass filtering processing for removing the DC components and waveform shaping processing or pre-emphasis processing for improving the performance of subsequent encoding processing, with respect to an input speech signal, and outputs the signal (Xin) after these processings, to LPC analyzing section 102 and adding section 105.
LPC analyzing section 102 performs a linear prediction analysis using Xin, and outputs the analysis result (i.e. linear prediction coefficients) to LPC quantization section 103. LPC quantization section 103 carries out quantization processing of linear prediction coefficients (LPC's) out putted from LPC analyzing section 102, and outputs the quantized LPC' s to synthesis filter 104 and a code (L) representing the quantized LPC's to multiplexing section 114.
Synthesis filter 104 carries out filter synthesis for an excitation outputted from adding section 111 (explained later) using filter coefficients based on the quantized LPC's, to generate a synthesized signal and output the synthesized signal to adding section 105.
Adding section 105 inverts the polarity of the synthesized signal and adds the signal to Xin to calculate an error signal, and outputs the error signal to perceptual weighting section 112.
Adaptive excitation codebook 106 stores past excitations outputted from adding section 111 in a buffer, clips one frame of samples from the past excitations as an adaptive excitation vector that is specified by a signal outputted from parameter determining section 113, and outputs the adaptive excitation vector to multiplying section 109.
Gain codebook 107 outputs the gain of the adaptive excitation vector that is specified by the signal outputted from parameter determining section 113 and the gain of a fixed excitation vector to multiplying section 109 and multiplying section 110, respectively.
Fixed excitation codebook 108 stores a plurality of pulse excitation vectors of a predetermined shape in a buffer, and outputs a fixed excitation vector acquired by multiplying by a dispersion vector a pulse excitation vector having a shape that is specified by the signal outputted from parameter determining section 113, to multiplying section 110.

Multiplying section 109 multiplies the adaptive excitation vector outputted from adaptive excitation codebook 106, by the gain outputted from gain codebook 107, and outputs the result to adding section 111. Multiplying section 110 multiplies the fixed excitation vector outputted from fixed excitation codebook 108, by the gain outputted from gain codebook 107, and outputs the result to adding section 111.

Adding section 111 receives as input the adaptive excitation vector and fixed excitation vector after gain multiplication, from multiplying section 109 and multiplying section 110, adds these vectors, and outputs an excitation representing the addition result to synthesis filter 104 and adaptive excitation codebook 106. Further, the excitation inputted to adaptive excitation codebook 106 is stored in a buffer.

Perceptual weighting section 112 applies perceptual weighting to the error signal outputted from adding section 105, and outputs the error signal to parameter determining section 113 as coding distortion.

Parameter determining section 113 searches for the codes for the adaptive excitation vector, fixed excitation vector and quantization gain that minimize the coding distortion outputted from perceptual weighting section 112, and outputs the searched code (A) representing the adaptive excitation vector, code (F) representing the fixed excitation vector and code (G) representing the quantization gain, to multiplexing section 114.

Multiplexing section 114 receives as input the code (L) representing the quantized LPC's from LPC quantization section 103, receives as input the code (A) representing the adaptive excitation vector, the code (F) representing the fixed excitation vector and the code (G) representing the quantization gain, and multiplexes these items of information to output encoded information.

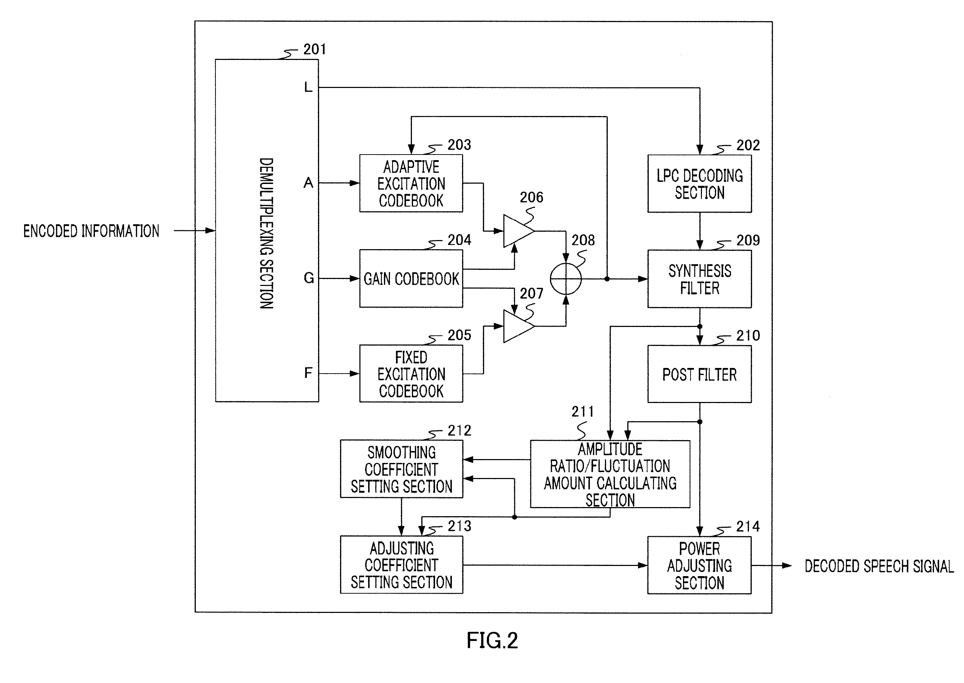

FIG.2 is a block diagram showing a configuration of the speech decoding apparatus according to the present embodiment. In FIG.2, the encoded information is demultiplexed in demultiplexing section 201 into individual codes (L, A, G and F). The code (L) representing the quantized LPC's is outputted to LPC decoding section 202, the code (A) representing the adaptive excitation vector is outputted to adaptive excitation codebook 203, the code (G) representing the quantization gain is outputted to gain codebook 204 and the code (F) representing the fixed excitation vector is outputted to fixed excitation codebook 205.

LPC decoding section 202 decodes a quantized LSP parameter from the code (L) representing the quantized LPC's, retransforms the resulting quantized LSP parameter to a quantized LPC parameter, and outputs the quantized LPC parameter to synthesis filter 209.

Adaptive excitation codebook 203 stores past excitations used in synthesis filter 209, extracts one frame of samples as an adaptive excitation vector from the past excitations that are specified by an adaptive codebook lag associated with the code (A) representing the adaptive excitation vector and outputs the adaptive excitation vector to multiplying section 206. Further, adaptive excitation codebook 203 updates the stored excitations using the excitation outputted from adding section 208.

Gain codebook 204 decodes the gain of the adaptive excitation vector that is specified by the code (G) representing the quantization gain and the gain of the fixed excitation vector, and outputs the gain of the adaptive excitation vector and the gain of the fixed excitation vector to multiplying section 206 and multiplying section 207, respectively.

Fixed excitation codebook 205 stores a plurality of pulse excitation vectors of a predetermined shape in the buffer, generates a fixed excitation vector obtained by multiplying by a dispersion vector a pulse excitation vector having a shape that is specified by the code (F) representing the fixed excitation vector, and outputs the fixed excitation vector to multiplying section 207.

Multiplying section 206 multiplies the adaptive excitation vector by the gain and outputs the result to adding section 208. Multiplying section 207 multiplies the fixed excitation vector by the gain and outputs the result to adding section 208.

Adding section 208 adds the adaptive excitation vector and fixed excitation vector after gain multiplication outputted from multiplying sections 206 and 207 to generate an excitation, and outputs this excitation to synthesis filter 209 and adaptive excitation codebook 203.

Synthesis filter 209 carries out filter synthesis of the excitation outputted from adding section 208 using the filter coefficients decoded in LPC decoding section 202, and outputs the resulting signal (hereinafter "first synthesized signal") to post filter 210 and amplitude ratio/fluctuation amount calculating section 211.

Post filter 210 carries out processing for improving the subjective quality of speech such as formant emphasis and pitch emphasis, and processing for improving the subjective quality of stationary noise, with respect to the signal outputted from synthesis filter 209, and outputs the resulting signal (hereinafter "second synthesized signal") to amplitude ratio/fluctuation amount calculating section 211 and power adjusting section 214. Further, there may be cases where post filter 210 skips a pitch analysis to reduce the amount of calculation and applies filtering utilizing the adaptive codebook lag and the gain of the adaptive excitation vector of adaptive excitation codebook 203.

Amplitude ratio/fluctuation amount calculating section 211 calculates on a per subframe basis the amplitude ratio of the first synthesized signal of the input signal of post filter 210 and the second synthesized signal of the output signal of post filter 210, and the amount of fluctuation of the amplitude ratio, outputs the calculated amplitude ratio to smoothing coefficient setting section 212 and adjusting coefficient setting section 213, and outputs the amount of fluctuation of the calculated amplitude ratio to smoothing coefficient setting section 212.

Smoothing coefficient setting section 212 sets the smoothing coefficients on a per subframe basis using the amplitude ratio of the first synthesized signal and the second synthesized signal, and the amount of fluctuation of the amplitude ratio, and outputs the set smoothing coefficients to adjusting coefficient setting section 213.

Adjusting coefficient setting section 213 sets the adjusting coefficients on a per sample basis using the amplitude ratio of the first synthesized signal and the second synthesized signal and the smoothing coefficients, and outputs the set adjusting coefficients to power adjusting section 214.

Power adjusting section 214 multiplies the second synthesized signal by the adjusting coefficients to adjust the power of the second synthesized signal and acquires the final decoded speech signal.

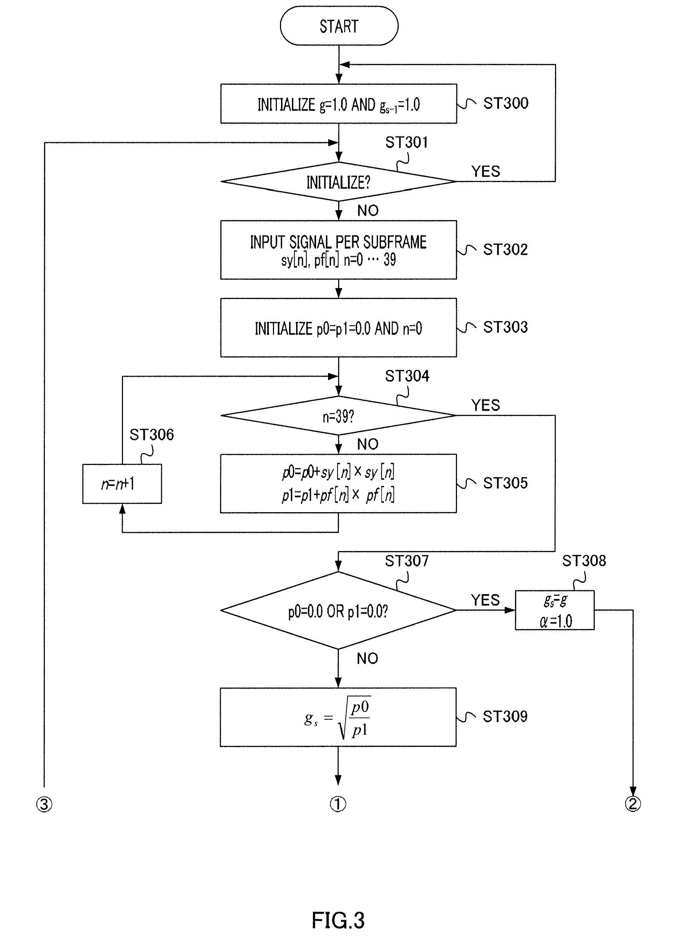

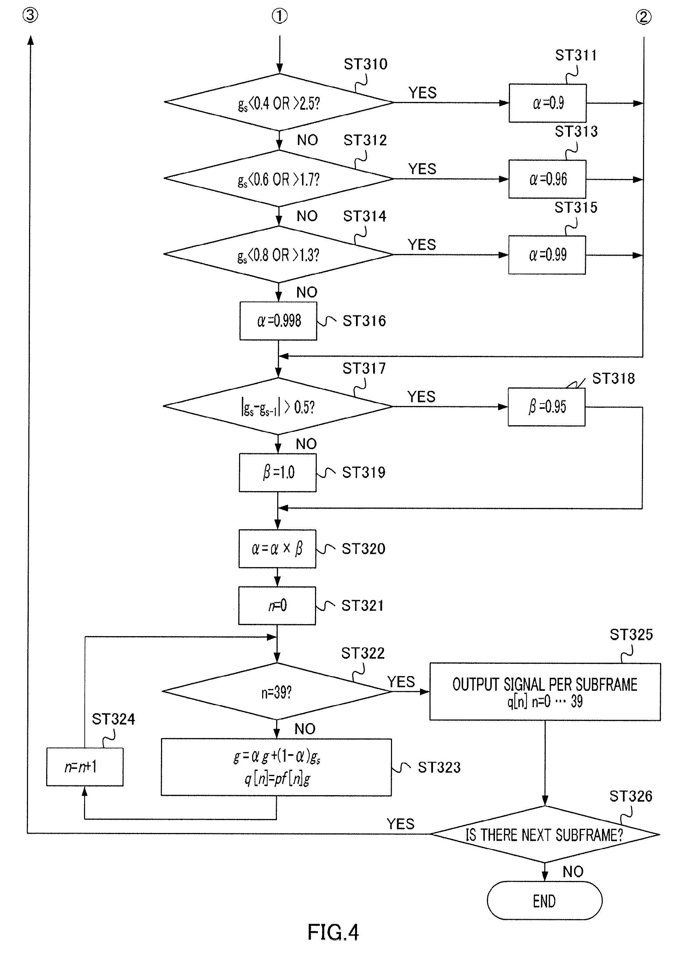

Next, the power adjustment algorithm in the speech decoding apparatus according to the present embodiment will be explained using FIG.3 and FIG.4. Further, the values used in the algorithm shown in FIG.3 and FIG.4 will be represented by the following symbols. Further, in FIG.3 and FIG.4, the numerical values of constants are set assuming the sampling rate is 8 kHz and the subframe length is 5 ms, which are the units used in general low bit rate codecs for telephones.

n: the sample value

p0: the power of the first synthesized signal

p1: the power of the second synthesized signal

$g_s$: the amplitude ratio of the current subframe

$g_{s-1}$: the amplitude ratio of the previous subframe

g: the adjusting coefficient

$\alpha$: the smoothing coefficient

$\beta$: the stationary scale

sy[n]: the first synthesized signal in sample n

pf[n]: the second synthesized signal in sample n

q[n]: the decoded speech signal

First, the adjusting coefficients g and the amplitude ratio $g_{s-1}$ of the previous frame are initialized to 1.0 before the operation of the speech decoding apparatus starts (ST 300 and ST 301).

Next, the first synthesized signals and the second synthesized signals of all sampling timings are inputted on a per subframe basis (ST 302), the power p0 of the first synthesized signals, the power p1 of the second synthesized signals and the sample value n are initialized to 0 (ST 303) and the power p0 of the first synthesized signal and the power p1 of the second synthesized signal in the current subframe are determined (ST 304, ST 305 and ST 306).

Then, if there is 0 in one of the power p0 of the first synthesized signals and the power p1 of the second synthesized signals (ST 307: YES), the mode enters exceptional mode, the value of the adjusting coefficient g updating the past adjusting coefficients is assigned to the amplitude ratio $g_s$ of the current frame, and the smoothing coefficients $\alpha$ is set to 1.0 (ST 308). Further, only one of these two processings in ST 308 needs to be carried out.

By contrast with this, if neither the power p0 of the first synthesized signals nor the power p1 of the second synthesized signal p1 is 0 (ST 307: NO), the power P0 of the first synthesized signals is divided by the power p1 of the second synthesized signal, the square root of the division result is calculated and the amplitude ratio $g_s$ of the current subframe is determined (ST 309). Further, the portions of ST 303, ST 304, ST 305, ST 306, ST 307 and ST 309 are represented by the following equation 1.

[1]

$$g_s = \sqrt{\frac{\sum_n sy[n] \times sy[n]}{\sum_n pf[n] \times pf[n]}} \quad \text{… where } g_s \text{ is 1 when the denominator is}$$

0. … (Equation 1)

Next, the smoothing coefficients $\alpha$ are set depending on the magnitude of the amplitude ratio $g_s$ of the current subframe. FIG.4 shows four patterns of setting examples. That is, in case of $g_s < 0.4$ or $g_s > 2.5$, $\alpha = 0.9$ is set (ST 310: YES and ST 311) . Further, in cases apart from the above case and in case of $g_s < 0.6$ or $g_s > 1.7$, $\alpha = 0.96$ is set (ST 310: NO, ST 312:YES and ST 313). Furthermore, in cases apart from the above two cases and in case of $g_s < 0.8$ or $g_s > 1.3$,

$\alpha$=0.99 is set (ST 312:NO, ST 314 :YES and ST 315). Further, in cases apart from the above three cases, $\alpha$=0.998 is set (ST 314:NO and ST 316).

Here, when the amplitude ratio $g_s$ of the current subframe is closer to 1.0, the smoothing coefficients $\alpha$ are set closer to 1.0. On the other hand, when the smoothing coefficients $\alpha$ become closer to 1.0, the accelerating coefficients $(1-\alpha)$ become closer to 0.0. This process is an important element with the present invention, and, thanks to this setting, when post filter processing changes power significantly, the power is adjusted promptly and, when post filter processing does not change power much, the power is adjustedmore smoothly.

Next, when the absolute value $|g_s-g_{s-1}|$ of the difference between the amplitude ratio $g_{s-1}$ of the previous subframe and the amplitude ratio $g_s$ of the current subframe, is greater than a predetermined threshold, the stationary scale $\beta$ is set small and, when the absolute value $|g_s-g_{s-1}|$ is equal to or less than a predetermined threshold, the stationary scale $\beta$ is set great. In FIG.4, as a setting example, when $|g_s-g_{s-1}|$ is greater than 0.5, $\beta$=0.95 is set, and, when $|g_s-g_{s-1}|$ is equal to or less than 0.5, $\beta$=1.0 is set (ST 317, ST 318 and ST 319).

Then, new smoothing coefficients $\alpha$ are acquired by multiplying the smoothing coefficients $\alpha$ by the stationary scale $\beta$ (ST 320). In this way, it is possible to provide an advantage of adjusting the power promptly by multiplying the smoothing coefficients $\alpha$ by the stationary scale $\beta$ when fluctuation over time is significant.

Next, the adjusting coefficients g are calculated based on the determined amplitude ratio $g_s$ of the current subframe and smoothing coefficients $\alpha$. To be more specific, new adjusting coefficients g are calculated by multiplying the adjusting coefficients g of the previous sample by smoothing coefficients $\alpha$, multiplying the amplitude ratio $g_s$ of the current subframe by the accelerating coefficients $(1-\alpha)$ and adding the multiplication results. Then, the final decoded speech signal q[n] is acquired by multiplying the second synthesized signal pf[n] by the adjusting coefficients g (ST 321, ST 322, ST 323 and ST 324).

One subframe of the resulting decoded speech signal q[n] is outputted (ST 325).

The above processings are repeated in the next subframe (ST 326). Further, the adjusting coefficients g that are used lately are used as is in the next subframe. Further, the amplitude ratio $g_s$ of the current subframe determined in ST 308 and ST 309 is used as the amplitude ratio $g_{s-1}$ of the previous subframe in processing of the next subframe.

In this way, according to the present embodiment, it is possible to adjust the power promptly when the post filter changes the power significantly or fluctuates the amplitude ratio significantly over time, and realize smooth power adjustment without discontinuity in a period in which the post filter fluctuates power little or in a period which is stationary over time. Consequently, it is possible to produce good synthesized sound with a stable sound volume according to the present embodiment.

Furhter, although constants have been set assuming that the sampling frequency is 8 kHz and subframe length is 5 ms (40 samples) with the present embodiment, the sampling frequency and the subframe length of the present invention are not limited to these and other sampling frequencies and subframe lengths are also effective. For example, when sampling is performed at the 16 kHz sampling rate which is twice as much as the sampling rate of 8 kHz, the subframe unit is 80 samples and good performance is achieved by setting values of the smoothing coefficients greater. For example, it is possible to achieve good performance matching the sampling rate by setting the constants of the smoothing coefficients {0.9, 0.96, 0.99, 0.998} to {0.95, 0.98, 0.993, 0.999} and setting the stationary scales {0.95, 1.0} to about {0.97, 1.0}.

Further, although a case has been explained with the present embodiment where the amplitude ratio is referred to decide the smoothing coefficients and stationary scale, the present invention is not limited to this and it is possible to provide the same advantage even when the power ratio is used instead of the amplitude ratio. Further, the power ratio is highly correlated with the square of the amplitude ratio.

By contrast with this, although the square root of the ratio of square sums of the two signals is calculated to determine the adjusting coefficients of the current subframe, the present invention is not limited to this, and it is possible to provide the same advantage even when the ratio of the sums of the absolute values of the signals is used.

Further, although a power adjusting section for adjusting fluctuation of input/output power of a post filter has been explained with the present embodiment, the present invention is not limited to the post filter and is effective when input/output power fluctuates. For example, although vocal sound emphasis processing used in hearing instrument and the like requires power adjustment to prevent sudden power fluctuation, the present invention is substantially effective in this case, so that it is possible to realize smooth perceptual sound quality of speech that is easy to hear.

Further, although the present embodiment is used for CELP, the present invention is also effective for other codecs. This is because the power adjusting section of the present invention is used in processing subsequent to decoder processing and does not depend on the types of codecs.

Further, although a fixed excitation vector is generated by multiplying a pulse excitation vector by a dispersion vector in a fixed excitation codebook with the present embodiment, the present invention is not limited to this, and the pulse excitation vector may be used as is for the fixed excitation vector.

Furthermore, the speech decoding apparatus according to the present invention can be provided in a communication terminal apparatus and base station apparatus in a mobile communication system, so that it is possible to provide a communication terminal apparatus base station apparatus and mobile communication system having the same operations and advantages as explained above.

Also, although cases have been explained here as examples where the present invention is configured by hardware, the present invention can also be realized by software. For example, it is possible to implement the same functions as in the base station apparatus according to the present invention by describing algorithms according to the present invention using the programming language, and executing this program with an information processing section by storing this program in the memory.

Each function block employed in the explanation of each of the aforementioned embodiment may typically be implemented as an LSI constituted by an integrated circuit. These may be individual chips or partially or totally contained on a single chip.

"LSI" is adopted here but this may also be referred to as "IC," "system LSI," "super LSI," or "ultra LSI" depending on differing extents of integration.

Further, the method of circuit integration is not limited to LSI's, and implementation using dedicated circuitry or general purpose processors is also possible. After LSI manufacture, utilization of a programmable FPGA (Field Programmable Gate Array) or a reconfigurable processor where connections and settings of circuit cells within an LSI can be reconfigured is also possible.

Further, if the integrated circuit technology comes out to replace LSI's as a result of the advancement of semiconductor technology or a derivative other technology, it is also naturally possible to carry out function block integration using this technology. Application of biotechnology is also possible.

The disclosure of Japanese Patent Application No.2006-336272, filed on December 13, 2006, including the specification, drawings and abstract, is incorporated herein by reference in its entirety.

Industrial Applicability

The present invention is suitable for use in a speech decoding apparatus and the like for decoding an encoded speech signal.

**Claims**

1. A speech decoding apparatus comprising:

a post filter that applies filtering to a signal of a subframe length at predetermined sample timing intervals;
a calculating section that calculates a first calculation value and a second value on a per subframe basis, the first calculation value comprising an amplitude ratio or a power ratio of an input signal and an output signal of the post filter, the second calculation value comprising an amount of fluctuation of the first calculation value;
a smoothing coefficient setting section that sets a smoothing coefficient on a per subframe basis based on the first calculation value and the second calculation value;
an adjusting coefficient setting section that sets an adjusting coefficient on a per sample basis based on the first calculation value and the smoothing coefficient; and
a power adjusting section that acquires a decoded speech signal by multiplying the output signal of the post filter by the adjusting coefficient.

2. The speech decoding apparatus according to claim 1, wherein the smoothing coefficient setting section sets the smoothing coefficient closer to 1.0 when the first calculation value is closer to 1.0.

3. The speech decoding apparatus according to claim 1, wherein the adjusting coefficient setting section adds a value multiplying the adjusting coefficient of a previous sample by the smoothing coefficient, and a value multiplying the first calculation value by an accelerating coefficient subtracting the smoothing coefficient from 1.0, to calculate a new adjusting coefficient.

4. A power adjusting method for an output signal of a post filter for applying filtering to a signal of a subframe length at predetermined sample timing intervals, the power adjusting method comprising:

calculating a first calculation value and a second calculation value on a per subframe basis, the first calculation value comprising an amplitude ratio or a power ratio of an input signal and the output signal of the post filter, the second calculation value comprising an amount of fluctuation of the first calculation value;
setting a smoothing coefficient on a per subframe basis based on the first calculation value and the second calculation value;
setting an adjusting coefficient on a per sample basis based on the first calculation value and the smoothing coefficient; and
multiplying the output signal of the post filter by the adjusting coefficient.

FIG.1

FIG.2

START

INITIALIZE g=1.0 AND $g_{s-1}$=1.0 — ST300

ST301

INITIALIZE? — YES

NO

INPUT SIGNAL PER SUBFRAME
sy[n], pf[n] n=0 ⋯ 39 — ST302

INITIALIZE p0=p1=0.0 AND n=0 — ST303

ST304

n=39? — YES

NO

ST306

$n=n+1$

$p0=p0+sy[n] \times sy[n]$
$p1=p1+pf[n] \times pf[n]$ — ST305

ST307

ST308

p0=0.0 OR p1=0.0? — YES — $g_s=g$
$\alpha=1.0$

NO

$$g_s = \sqrt{\dfrac{p0}{p1}}$$ — ST309

③        ①        ②

FIG.3

③                                ①                                ②

ST310
$g_s$ <0.4 OR >2.5?  —YES→  ST311  $\alpha$ =0.9

NO          ST312
$g_s$ <0.6 OR >1.7?  —YES→  ST313  $\alpha$ =0.96

NO          ST314
$g_s$ <0.8 OR >1.3?  —YES→  ST315  $\alpha$ =0.99

NO

$\alpha$ =0.998  ST316

ST317
$|g_s - g_{s-1}| > 0.5?$  —YES→  ST318  $\beta$ =0.95

NO

$\beta$ =1.0  ST319

$\alpha = \alpha \times \beta$  ST320

$n=0$  ST321

ST322
n=39?  —YES→  ST325  OUTPUT SIGNAL PER SUBFRAME $q[n]$ n=0 … 39

ST324          NO

$n=n+1$          $g = \alpha g + (1-\alpha)g_s$
                 $q[n] = pf[n]g$  ST323

YES
ST326
IS THERE NEXT SUBFRAME?

NO

END

FIG.4

## INTERNATIONAL SEARCH REPORT

| | International application No. |
|---|---|
| | PCT/JP2007/073968 |

A. CLASSIFICATION OF SUBJECT MATTER
*G10L19/14(2006.01)i, G10L11/00(2006.01)i*

According to International Patent Classification (IPC) or to both national classification and IPC

B. FIELDS SEARCHED

Minimum documentation searched (classification system followed by classification symbols)
G10L11/00-21/06

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)
JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| A | JP 9-190195 A (Toshiba Corp.),<br>22 July, 1997 (22.07.97),<br>Full text; all drawings<br>& US 5864798 A | 1-4 |
| A | JP 9-138697 A (Toshiba Corp.),<br>27 May, 1997 (27.05.97),<br>Full text; all drawings<br>& US 6064962 A          & EP 763818 A2 | 1-4 |
| A | JP 10-214100 A (Sony Corp.),<br>11 August, 1998 (11.08.98),<br>Full text; all drawings<br>(Family: none) | 1-4 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>27 February, 2008 (27.02.08) | Date of mailing of the international search report<br>11 March, 2008 (11.03.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2007/073968 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 7-160296 A  (NEC Corp.),<br>23 June, 1995 (23.06.95),<br>Full text; all drawings<br>& US 5659661 A          & EP 658875 A2 | 1-4 |
| A | JP 2000-305598 A  (Toshiba Corp.),<br>02 November, 2000 (02.11.00),<br>Full text; all drawings<br>(Family: none) | 1-4 |

Form PCT/ISA/210 (continuation of second sheet) (April 2007)

**REFERENCES CITED IN THE DESCRIPTION**

**Patent documents cited in the description**

- JP HEI9190195 B
- JP HEI9127996 B
- JP 2006336272 A